(19) **Europäisches Patentamt / European Patent Office / Office européen des brevets**

(11) **EP 4 734 080 A1**

(12) **EUROPEAN PATENT APPLICATION**
published in accordance with Art. 153(4) EPC

(43) Date of publication:
29.04.2026 Bulletin 2026/18

(21) Application number: 24856788.5

(22) Date of filing: 20.08.2024

(51) International Patent Classification (IPC):
$G07C\ 5/02^{(2006.01)}$  $G01R\ 31/00^{(2006.01)}$
$G01R\ 22/06^{(2006.01)}$  $G07C\ 5/00^{(2006.01)}$
$B60L\ 3/12^{(2006.01)}$

(52) Cooperative Patent Classification (CPC):
B60L 3/12; G01R 22/06; G01R 31/00; G07C 5/00;
G07C 5/02

(86) International application number:
PCT/KR2024/012332

(87) International publication number:
WO 2025/042177 (27.02.2025 Gazette 2025/09)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 23.08.2023 KR 20230110809

(71) Applicant: LG Energy Solution, Ltd.
Seoul 07335 (KR)

(72) Inventor: KIM, Kang San
Daejeon 34122 (KR)

(74) Representative: Goddar, Heinz J.
Boehmert & Boehmert
Anwaltspartnerschaft mbB
Pettenkoferstrasse 22
80336 München (DE)

(54) **ELECTRIC FUEL EFFICIENCY ANALYZING APPARATUS AND OPERATING METHOD THEREOF**

(57) An energy efficiency analysis device according to an embodiment disclosed in this document may comprise: a data acquisition unit configured to acquire driving information of a vehicle in a specified monitoring section; and a processor configured to classify the specified monitoring section into a plurality of behavioral factors according to a driving state on the basis of the driving information, calculate a standard energy efficiency contribution, which is a degree of affecting a energy efficiency of the vehicle by each of the plurality of behavioral factors, and calculate a score for each of the plurality of behavioral factors on the basis of the standard energy efficiency contribution.

ENERGY EFFICIENCY ANALYSIS DEVICE
30

DATA ACQUISITION UNIT
110

MEMORY
120

OUTPUT DEVICE
130

PROCESSOR
140

FIG.1B

EP 4 734 080 A1

**Description**

**Technical Field**

CROSS-REFERENCE TO RELATED APPLICATION

This application claims priority to and the benefit of Korean Patent Application No. 10-2023-0110809 filed in the Korean Intellectual Property Office on August 23, 2023, the entire contents of which are incorporated herein by reference.

TECHNICAL FIELD

Various embodiments disclosed in this document relate to a energy efficiency analysis device and an operating method thereof.

**Background Art**

Recently, distribution of eco-friendly vehicles, such as electric vehicles, fuel cell vehicles, and the like, is increasing due to environmental problems. These eco-friendly vehicles are equipped with batteries and run using electric energy of the batteries.

A vehicle provides a function of calculating energy efficiency (or driving energy efficiency) of the vehicle and outputting the energy efficiency through a cluster or the like. The energy efficiency may be calculated as the distance that can be driven per 1 kWh of electric energy.

Generally, energy efficiency may be calculated based on the driving distance of a predetermined section and the amount of electric energy consumed. For example, the energy efficiency can be calculated as a ratio of the amount of electric energy consumed to the driving distance.

Providing the energy efficiency may help drivers to make a plan for charging while driving or before driving. However, the energy efficiency may vary according to the situations of roads, driving habits of a driver, conditions of a vehicle, and the like even when the vehicles are of the same type, and drivers may not recognize which factors affect the energy efficiency only through the provided energy efficiency.

**Disclosure**

**Technical Problem**

An object of various embodiments of the present invention is to provide an energy efficiency analysis device configured to analyze factors that affect energy efficiency of a vehicle, and an operating method thereof.

Another object of various embodiments of the present invention is to provide a energy efficiency analysis device configured to analyze causes of increasing or decreasing current energy efficiency of a vehicle compared to a standard energy efficiency of the vehicle, and an operating method thereof.

The technical problems of the embodiments disclosed in this document are not limited to the technical problems mentioned above, and unmentioned other technical problems will be clearly understood by those skilled in the art from the following descriptions.

**Technical Solution**

An energy efficiency analysis device according to an embodiment disclosed in this document may comprise: a data acquisition unit configured to acquire driving information of a vehicle in a specified monitoring section; and a processor configured to classify the specified monitoring section into a plurality of behavioral factors according to a driving state on the basis of the driving information, calculate a standard energy efficiency contribution, which is a degree of affecting a energy efficiency of the vehicle by each of the plurality of behavioral factors, and calculate a score for each of the plurality of behavioral factors on the basis of the standard energy efficiency contribution.

According to an embodiment, the processor may classify the specified monitoring section into a plurality of speed sections that satisfy a specified speed condition on the basis of the driving information, classify each of the plurality of speed sections into a plurality of behavioral factors that satisfy a specified speed change condition, and calculate a standard energy efficiency contribution for each of the plurality of behavioral factors.

According to an embodiment, the processor may classify each of the plurality of speed sections into a plurality of behavioral factors on the basis of whether a starting speed or an ending speed is 0 in each of the plurality of speed sections.

According to an embodiment, the processor may calculate a energy efficiency profit/loss value indicating a profit or loss of a current energy efficiency of the vehicle compared to a standard energy efficiency of the vehicle on the basis of the driving information, and calculate the standard energy efficiency contribution on the basis of the energy efficiency profit/loss value.

According to an embodiment, the processor may calculate the standard energy efficiency contribution indicating a degree of affecting a profit or loss of the current energy efficiency by driving of the vehicle in the specified monitoring section compared to the standard energy efficiency, on the basis of the power consumption rate of the vehicle and the energy efficiency profit/loss value in the specified monitoring section.

According to an embodiment, the processor may calculate a score for each of the plurality of behavioral factors on the basis of a probability distribution function related to the standard energy efficiency contribution of each of the plurality of behavioral factors.

According to an embodiment, the processor may estimate the probability distribution function on the basis of previously acquired data related to the standard energy efficiency contribution of each of the plurality of behavioral factors, and calculate a score for each of the plurality of behavioral factors on the basis of a probability corresponding to the standard energy efficiency contribution of the vehicle from the probability distribution function.

An energy efficiency analysis method according to an embodiment disclosed in this document may comprise the steps of: classifying, on the basis of driving information of a vehicle acquired in a specified monitoring section, the specified monitoring section into a plurality of behavioral factors according to a driving state; calculating a standard energy efficiency contribution, which is a degree of affecting a energy efficiency of the vehicle by each of the plurality of behavioral factors; and calculating a score for each of the plurality of behavioral factors on the basis of the standard energy efficiency contribution.

According to an embodiment, the step of classifying the specified monitoring section into a plurality of behavioral factors may include the steps of: classifying the specified monitoring section into a plurality of speed sections that satisfy a specified speed condition on the basis of the driving information; classifying each of the plurality of speed sections into a plurality of behavioral factors that satisfy a specified speed change condition; and calculating a standard energy efficiency contribution for each of the plurality of behavioral factors.

According to an embodiment, the step of classifying the specified monitoring section into a plurality of behavioral factors may include the step of classifying each of the plurality of speed sections into a plurality of behavioral factors on the basis of whether a starting speed or an ending speed is 0 in each of the plurality of speed sections.

According to an embodiment, the step of calculating a standard energy efficiency contribution may include the steps of: calculating a energy efficiency profit/loss value indicating a profit or loss of a current energy efficiency of the vehicle compared to a standard energy efficiency of the vehicle on the basis of the driving information; and calculating the standard energy efficiency contribution on the basis of the energy efficiency profit/loss value.

According to an embodiment, the energy efficiency analysis method may further comprise, after the step of calculating a energy efficiency profit/loss value, the step of calculating the standard energy efficiency contribution indicating a degree of affecting a profit or loss of the current energy efficiency by driving of the vehicle in the specified monitoring section compared to the standard energy efficiency, on the basis of the power consumption rate of the vehicle and the energy efficiency profit/loss value in the specified monitoring section.

According to an embodiment, the step of calculating a score for each of the plurality of behavioral factors may include the step of calculating a score for each of the plurality of behavioral factors on the basis of a probability distribution function related to the standard energy efficiency contribution of each of the plurality of behavioral factors.

According to an embodiment, the step of calculating a score for each of the plurality of behavioral factors may include the steps of: estimating the probability distribution function on the basis of previously acquired data related to the standard energy efficiency contribution of each of the plurality of behavioral factors; and calculating a score for each of the plurality of behavioral factors on the basis of a probability corresponding to the standard energy efficiency contribution of the vehicle from the probability distribution function.

**Advantageous Effects**

The energy efficiency analysis device and an operating method thereof according to an embodiment disclosed in this document may analyze factors that affect energy efficiency of a vehicle.

The energy efficiency analysis device and an operating method thereof according to an embodiment disclosed in this document may analyze causes of increasing or decreasing current energy efficiency of a vehicle compared to a standard energy efficiency of the vehicle.

In addition, various effects directly or indirectly grasped through this document can be provided.

**Description of Drawings**

FIG. 1a is a view schematically showing the configuration of a energy efficiency analysis system according to an embodiment disclosed in this document.

FIG. 1b is a view showing the configuration of a energy efficiency analysis device according to an embodiment disclosed in this document.

FIG. 2a is a view showing behavioral factors according to an embodiment disclosed in this document.

FIG. 2b is a view showing driving speeds according to an embodiment disclosed in this document.

FIGS. 3a and 3b are views showing in detail the driving speeds according to an embodiment disclosed in this document.

FIG. 4a and FIG. 4b are views for explaining the operation of calculating a standard energy efficiency contribution according to an embodiment disclosed in this document.

FIG. 5a and FIG. 5b are views for explaining the operation of calculating scores for behavioral factors according to an embodiment disclosed in this document.

FIGS. 6a to 6e are views for explaining the output operation of a energy efficiency analysis device according to an embodiment disclosed in this document.

FIG. 7 is a flowchart for explaining the operation of a energy efficiency analysis device according to an embodiment disclosed in this document.

FIG. 8 is a flowchart for explaining the operation of calculating a power consumption rate and a energy efficiency profit/loss value by a energy efficiency analysis device according to an embodiment disclosed in this document.

FIG. 9 is a block diagram showing the hardware configuration of a computing system configured to implement a energy efficiency analysis device according to an embodiment disclosed in this document.

**Mode for Invention**

Hereinafter, various embodiments of the present invention will be described with reference to the accompanying drawings. However, it should be understood that this is not intended to limit the present invention to specific embodiments, but includes various modifications, equivalents, and/or alternatives of the embodiments of the present invention.

It should be understood that the various embodiments of this document and the terms used therein are not intended to limit the technical features described in this document to specific embodiments, but include various modifications, equivalents, or substitutes of corresponding embodiments. In connection with the description of the drawings, similar reference numerals may be used for similar or related components. The singular form of a noun corresponding to an item may include one or more of the items, unless the related context clearly indicates otherwise.

In this document, each of the phrases such as "A or B", "at least one among A and B", "at least either A or B", "A, B or C", "at least among of A, B and C", and "at least either A, B, or C" may each include any one of the items listed together in a corresponding phrase among the phrases, or all possible combinations thereof. The terms "1st", "2nd", "first", "second", "A", "B", "(a)", or "(b)" may be used only to distinguish a corresponding component from another corresponding component, and do not limit the components in other aspects (e.g., importance or order), unless specifically stated otherwise.

In this document, when a certain (e.g., a first) component is referred to as being "connected", "coupled", or "combined" or referred to as being "coupled" or "connected" with or without a term such as "functionally" or "communicatively", it means that the component may be connected to another component directly (e.g., wired), wirelessly, or via a third component.

According to an embodiment, the method according to various embodiments disclosed in this document may be provided to be included in a computer program product. The computer program product may be traded between a seller and a buyer as goods. The computer program product may be distributed in the form of a machine-readable storage medium (e.g., a compact disc read only memory (CD-ROM)), or may be distributed online (e.g., downloaded or uploaded) through an application store or directly distributed between two user devices. In the case of online distribution, at least a part of the computer program product may be at least temporarily stored in a machine-readable storage medium, such as a memory of a manufacturer's server, an application store's server, or a relay server, or may be temporarily generated.

According to various embodiments, each component (e.g., a module or a program) of the components described above may include a single or a plurality of entities, and some of the plurality of entities may be separately disposed in other components. According to various embodiments, one or more of the components or operations of the components described above may be omitted, or one or more other components or operations may be added. Alternatively or additionally, a plurality of components (e.g., modules or a programs) may be integrated into a single component. In this case, the integrated component may perform one or more functions of each of the plurality of components in a way identical or similar to those performed by the corresponding component among the plurality of components before the integration. According to various embodiments, the operations performed by the modules, programs, or other components may be executed sequentially, in parallel, repeatedly, or heuristically, or one or more of the operations may be executed in a different order or omitted, or one or more other operations may be added.

The vehicle mentioned in the following description may include a vehicle driven by boarding and operation of a driver, and an autonomous vehicle having a function of driving itself without the operation of a driver. In addition, although an automobile is described as an example of the vehicle in the following description, the present invention is not limited thereto. For example, various embodiments described below may also be applied to various transportation means such as ships, airplanes, trains, motorcycles, bicycles, and the like.

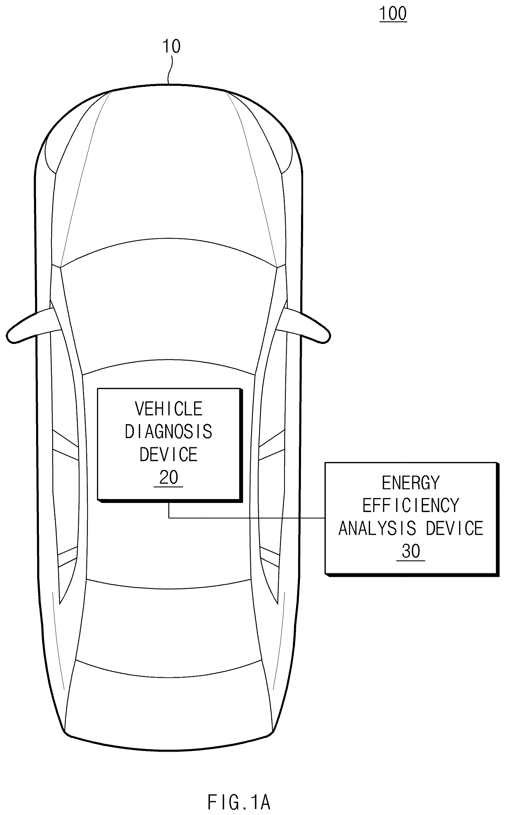

FIG. 1a is a view schematically showing the configuration of a energy efficiency analysis system according to an embodiment disclosed in this document.

Referring to FIG. 1a, a energy efficiency analysis system 100 according to an embodiment disclosed in this document may include a vehicle diagnosis device 20 and a energy efficiency analysis device 30. Here, the energy efficiency may be the amount of electric energy consumed by a vehicle 10 per unit driving distance or unit time.

According to an embodiment, the vehicle diagnosis device 20 may be provided inside the vehicle 10 to acquire information related to the state of the vehicle 10 or driving of the vehicle 10. The information related to the state of the vehicle 10 may include diagnostic information on the components of the vehicle 10 (e.g., battery, sensor, motor, accelerator, deceleration device, etc.). In addition, the information related to driving of the vehicle 10 may include speed information, driving distance information, driving time information, driving location information, fuel consumption information, and the like of the vehicle 10.

According to an embodiment, the vehicle diagnosis device 20 may include an On-Board Diagnostic (OBD) device. Such an OBD device may include various devices that output information related to the state or driving of the vehicle 10 to the outside (e.g., the energy efficiency analysis device 30), as well as OBD-I, OBD 1.5, and OBD-II.

According to an embodiment, the energy efficiency analysis device 30 may analyze energy efficiency of the vehicle 10 on the basis of various information acquired through the vehicle diagnosis device 20. According to an embodiment, the energy efficiency analysis device 30 may analyze factors that affect the energy efficiency of the vehicle 10. In another aspect, the energy efficiency analysis device 30 may calculate a standard energy efficiency contribution indicating the degree of affecting the energy efficiency of the vehicle 10 by a specific driving section.

According to an embodiment, the energy efficiency analysis device 30 may calculate a standard energy efficiency contribution that indicates the degree of affecting the profit or loss (e.g., increase or decrease) of the current energy efficiency of the vehicle 10 by the driving section of the vehicle 10 (or a section in which the electric energy of the vehicle 10 is consumed) compared to a standard energy efficiency (e.g., certified energy efficiency) of the vehicle 10. Here, the standard energy efficiency is a energy efficiency measured in a situation that satisfies a specified measurement condition, and may be measured by the vehicle diagnosis device 20 or the energy efficiency analysis device 30 or by a designated certification agency. For example, the energy efficiency analysis device 30 may include a portable communication device (e.g., a smart phone), a computer device, a portable multimedia device, a wearable device, or a server (e.g., a cloud server), and various embodiments are not limited thereto.

Details related to calculation of the standard energy efficiency contribution of the energy efficiency analysis device 30 according to an embodiment may be explained below in detail through the drawings.

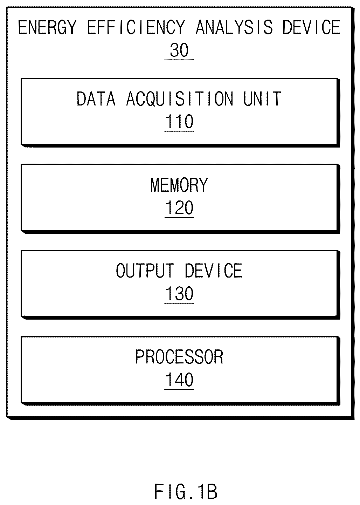

FIG. 1b is a block diagram showing the configuration of a energy efficiency analysis device according to an embodiment disclosed in this document.

Referring to FIG. 1b, the energy efficiency analysis device 30 may include a data acquisition unit 110, a memory 120, an output device 130, and a processor 140. However, this is only an example, and various embodiments are not limited thereto. For example, at least one of the components of the energy efficiency analysis device 30 described above may be omitted, or one or more other components (e.g., an input device, at least one sensor, a power management device, etc.) may be added as the configuration of the energy efficiency analysis device 30. In addition, at least one of the components described above may be integrated with another component.

According to an embodiment, the data acquisition unit 110 may acquire driving information of the vehicle 10. Here, the driving information may be information collected from the vehicle 10 while the vehicle 10 is driving in a predetermined section. According to an embodiment, the driving information may be information on a driving distance and an amount of electric energy consumed. According to an embodiment, the driving information may include at least one among a driving time, a driving distance, a speed, a velocity, an amount of electric energy consumed, and a temperature of the vehicle 10 driving in a predetermined section.

According to an embodiment, the data acquisition unit 110 may acquire driving information of the vehicle 10 from the vehicle diagnosis device 20 and/or an external server connected through a wired and/or wireless network. According to an embodiment, the data acquisition unit 110 may acquire driving information of other vehicles (not shown) other than the vehicle 10. The other vehicles may be vehicles of a type the same as or different from the type of the vehicle 10.

According to an embodiment, the data acquisition unit 110 may establish a wired or wireless communication channel between the energy efficiency analysis device 30 and the vehicle diagnosis device 20, and support communications performed through the established communication channel. In addition, the data acquisition unit 110 may also form communications with other external devices (e.g., a server), in addition to the vehicle diagnosis device 20.

According to an embodiment, the data acquisition unit 110 may include a communication circuit. For example, the data acquisition unit 110 may include a wireless communication circuit (e.g., a cellular communication circuit or a short-range wireless communication circuit) or a wired communication circuit (e.g., a local area network (LAN) communication circuit or a power line communication circuit).

In an embodiment, the memory 120 may store data used by at least one component (e.g., the processor 140) of the energy efficiency analysis device 30. For example, the data may include software (or instructions related thereto), input data, or output data. In an embodiment, the instructions, when executed by the processor 140, may allow the energy efficiency analysis device 30 to perform operations defined by the instructions.

According to an embodiment, the memory 120 may include one or more software programs.

According to an embodiment, the memory 120 may store data acquired from the data acquisition unit 110. For example, the memory 120 may store at least one among a driving time, a driving distance, a speed, a velocity, an amount of electric energy consumed, and a temperature, which are information related to driving of the vehicle 10.

According to an embodiment, the memory 120 may include a storage medium of at least one type among a memory of a flash memory type, a hard disk type, a micro type, and a card type (e.g., a Secure Digital Card (SD card) or an eXtream Digital Card (XD card)), and a memory of a Random Access Memory (RAM), a Static RAM (SRAM), a Read-Only Memory (ROM), a Programmable ROM (PROM), an Electrically Erasable PROM (EEPROM), a Magnetic RAM (MRAM), a magnetic disk, and an optical disk, but various embodiments are not limited thereto.

According to an embodiment, the output device 130 may output information related to the operation of the energy efficiency analysis device 30 to the outside of the energy efficiency analysis device 30. According to an embodiment, the output device 130 may include a display configured to output visual information. For example, the display may include any one or more among a liquid crystal display, a thin film transistorliquid crystal display, an organic light-emitting diode, a flexible display, a three-dimensional (3D) display, and a transparent display. In addition, the display may include a touch sensor set to detect a touch.

However, this is only an example, and various embodiments are not limited thereto. For example, the information related to the operation of the energy efficiency analysis device 30 may be provided as auditory information. In this case, the output device 130 may further include an audio output device (e.g., a speaker) configured to output acoustic signals to the outside of the energy efficiency analysis device 30.

According to an embodiment, the processor 140 may control at least one other component of the energy efficiency analysis device 30 (e.g., the data acquisition unit 110, the memory 120, and the output device 130) and perform various data processing or operations.

According to an embodiment, the processor 140 may execute software stored in the memory 120 to control at least one other component (e.g., hardware or software component) of the energy efficiency analysis device 30 connected to the processor 140 and perform various data processing or operations.

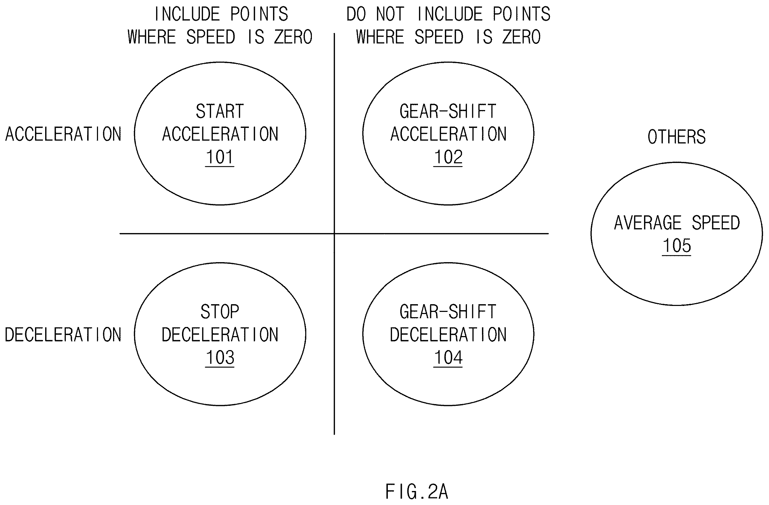

According to an embodiment, the processor 140 may analyze energy efficiency (or driving energy efficiency) of the vehicle 10 on the basis of various information acquired through the vehicle diagnosis device 20. The energy efficiency may be calculated as the distance that can be driven per 1 kWh of electric energy. The description related to the processor 140 will be described with reference to FIGS. 2a to 2b, 3a to 3b, 4a to 4b, 5a to 5b, and 6a to 6e described below.

Hereinafter, a method of analyzing energy efficiency of the vehicle 10 by the energy efficiency analysis device 30 through the processor 140 is described.

According to an embodiment, the processor 140 may calculate energy efficiency (or driving energy efficiency) of the vehicle 10 on the basis of various information acquired through the vehicle diagnosis device 20. According to an embodiment, the energy efficiency may be calculated as the distance that can be driven per 1 kWh of electric energy.

For example, the processor 140 may calculate energy efficiency (or driving energy efficiency) on the basis of driving information of the vehicle 10 acquired from the data acquisition unit 110. Here, the driving information may include information on the driving distance of a predetermined section and the amount of electric energy consumed. In this regard, the processor 140 may calculate the energy efficiency using the ratio of the amount of electric energy consumed to the driving distance.

Providing the energy efficiency may help drivers to make a plan for charging while driving or before driving. However, the energy efficiency may vary according to the situations of roads, driving habits of a driver, conditions of a vehicle, and the like even when the vehicles are of the same type, and drivers may not recognize the factors that affect formation of energy efficiency.

In this regard, the processor 140 may analyze factors that affect the energy efficiency of the vehicle 10 on the basis of various information acquired through the data acquisition unit 110 as described below. For example, the processor 140 may calculate a standard energy efficiency contribution indicating a degree of affecting the profit or loss (e.g., increase or decrease) of the current energy efficiency of the vehicle 10 compared to the standard energy efficiency (e.g., certified energy efficiency) of the vehicle 10.

According to an embodiment, the processor 140 may classify (or segment) a driving section, in which the electric energy of the vehicle 10 is consumed, into a plurality of sections, and calculate a standard energy efficiency contribution for each of the classified sections. According to an embodiment, the processor 140 may classify a driving section of the vehicle 10 into a plurality of behavioral factors based on the driving state of the vehicle 10.

According to an embodiment, the driving state of the vehicle 10 may be determined based on the speed of the vehicle 10. For example, the processor 140 may determine the driving state of the vehicle 10 based on at least one among the speed, change in the speed (i.e., acceleration), the starting speed, and the ending speed of the vehicle 10. According to an embodiment, the driving state of the vehicle 10 may be determined based on the amount of electric energy consumed. For example, the processor 140 may determine the driving state of the vehicle 10 based on the energy efficiency of the vehicle 10.

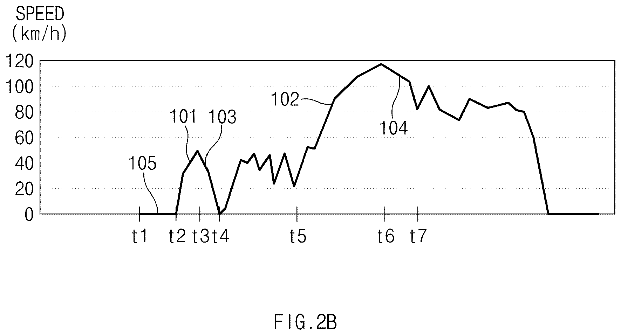

Classifying a driving section into a plurality of behavioral factors based on the driving state of the vehicle 10 by the processor 140 is explained with reference to FIGS. 2a and 2b.

FIG. 2a is a view showing behavioral factors according to an embodiment disclosed in this document. FIG. 2b is a view showing driving speeds according to an embodiment disclosed in this document.

Referring to FIG. 2a, a plurality of behavioral factors may be classified according to the driving state of the vehicle 10. The processor 140 may classify the driving section into a plurality of behavioral factors according to a criterion that may represent the driving state of the vehicle 10. For example, the processor 140 may classify the driving section into a plurality of behavioral factors based on the degree of affecting the energy efficiency by the driving state.

According to an embodiment, the processor 140 may classify a deceleration or acceleration section into a plurality of behavioral factors based on the magnitude of change in deceleration or acceleration (i.e., acceleration). According to an embodiment, the processor 140 may classify a section in which the magnitude of acceleration is greater than or equal to a predetermined criterion as rapid acceleration or rapid deceleration, and a section in which the magnitude of acceleration is lower than or equal to a predetermined criterion as acceleration or deceleration. For example, the processor 140 may classify acceleration and deceleration of 10 km/h or higher per second as rapid acceleration and rapid deceleration.

In an embodiment, the processor 140 may classify the behavioral factors on the basis of whether the vehicle 10 involves a start/stop. In an embodiment, the processor 140 may classify a deceleration or acceleration section into a plurality of behavioral factors on the basis of whether the deceleration or acceleration section includes a point where the speed is 0. In another aspect, the processor 140 may classify a deceleration or acceleration section into a plurality of behavioral factors on the basis of whether the start speed or the ending speed is 0 in the deceleration or acceleration section. For example, the processor 140 may classify a section where the vehicle 10 accelerates from a stationary state and a section where the vehicle decelerates to a stationary state as start acceleration 101 and stop deceleration 103, respectively, and classify an acceleration or deceleration section that does not include a stationary state of the vehicle 10 as gear-shift acceleration 102 or gear-shift deceleration 104, respectively.

According to an embodiment, a plurality of behavioral factors may include at least one among a start acceleration 101 section (e.g., a section including a starting speed of 0 and an acceleration of 20 km/h or higher per second), a gear-shift acceleration 102 section (e.g., a section including a starting speed of non-zero and an acceleration of 20 km/h or higher per second), a stop deceleration 103 section (e.g., a section including an ending speed of 0 and a deceleration of lower than 20 km/h per second), a gear-shift deceleration 104 section (e.g., a section including an ending speed of non-zero and a deceleration of lower than 20 km/h per second), and an average speed 105 section (e.g., a section where the average acceleration of the section is lower than 0.2).

Referring to FIG. 2b, the processor 140 may classify a driving section of the vehicle 10 into a plurality of behavioral factors. The graph shown in FIG. 2b may be a graph showing the speed (unit: km/h) of the vehicle 10 with respect to time (unit: second). According to an embodiment of FIG. 2a, section t1 to t2 may be an average speed 105 section, section t2 to t3 may be a start acceleration 101 section, and section t3 to t4 may be a stop deceleration 103 section. In addition, section t5 to t6 may be a gear-shift acceleration 102 section, and section t6 to t7 may be a gear-shift deceleration 104 section.

The processor 140 may effectively analyze the relation between the behavioral factors and energy efficiency of the vehicle 10 by classifying the behavioral factors of the vehicle 10 on the basis of whether or not a point where the speed is 0 is included, rather than the magnitude of acceleration. That is, classifying behavioral factors based on the magnitude of acceleration may not be ideal as a criterion for classifying behavioral factors of the vehicle 10. This is since there is no certified criterion for the magnitude of acceleration that can be applied to different vehicle types, and rapid acceleration and/or rapid deceleration inevitably has a bad effect on energy efficiency. In addition, since the rate of rapid acceleration/rapid deceleration occurring throughout the entire driving is small, classifying the behavioral factors based on the magnitude of acceleration and calculating the energy efficiency may have a problem.

On the contrary, classifying behavioral factors on the basis of whether a point where the speed is 0 is included, i.e., whether a start/stop is involved, may be a criterion that can be applied to different vehicle types. In addition, the rate of gear shift that involves a start/stop throughout the entire driving is higher than the rate of rapid acceleration/sudden deceleration. Therefore, classifying the behavioral factors on the basis of whether a start/stop is involved may be a classifying method that better represents driving of the vehicle 10. In addition, by analyzing the degree of affecting the energy efficiency of the vehicle 10 by each of the behavioral factors, the energy efficiency analysis device 30 may provide the user with information on the driving habits that positively or negatively affect the energy efficiency. Through this, the user may analyze the effect of each behavioral factor on the energy efficiency of the vehicle 10 and improve his or her driving habits and energy efficiency of the vehicle 10.

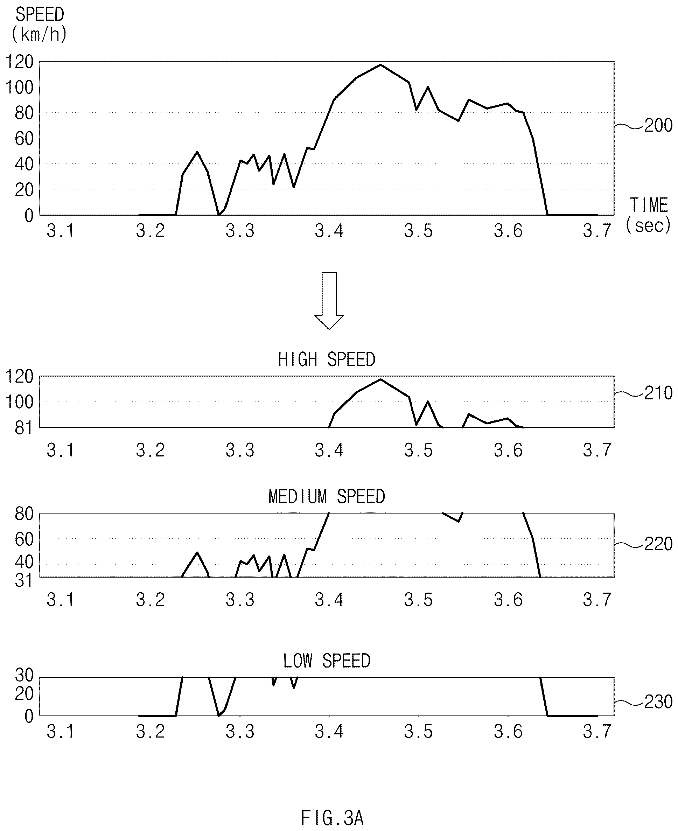

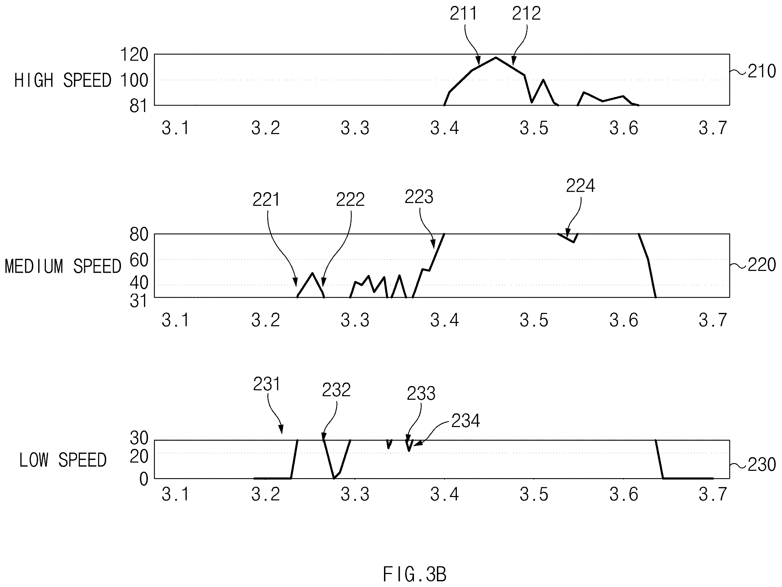

According to an embodiment, the processor 140 may classify the monitoring section, in which electric energy consumed by driving of the vehicle 10 is monitored, into a plurality of sections, and calculate a standard energy efficiency contribution for each of the classified sections. At this point, the processor 140 may classify the monitoring section into a plurality of speed sections. The calculation operation of the standard energy efficiency contribution in the monitoring section may be explained with reference to FIGS. 3a and 3b.

FIGS. 3a and 3b are views showing in detail the driving speeds according to an embodiment disclosed in this document.

Referring to FIG. 3a, the processor 140 may classify the monitoring section 200 based on the speed of the vehicle 10. For example, the processor 140 may classify the monitoring section 200 into a first section (e.g., high-speed section) 210 corresponding to a first speed range (e.g., 81 km/h or higher), a second section (e.g., medium-speed section) 220 corresponding to a second speed range (e.g., 31 to 80 km/h), and a third section (e.g., low-speed section) 230 corresponding to a third speed range (e.g., 1 to 30 km/h).

Thereafter, the processor 140 may calculate a first standard energy efficiency contribution, a second standard energy efficiency contribution, and a third standard energy efficiency contribution for the first section 210, the second section 220, and the third section 230, respectively.

According to an embodiment, the processor 140 may use <Equation 1> shown below to calculate the standard energy efficiency contribution.

Standard energy efficiency contribution = Power consumption rate * Energy efficiency profit/loss value     <Equation 1>

Power consumption rate = $E_i/E_T$, Energy efficiency profit and loss = $M_i/E_i - M_S/E_T$

In <Equation 1>, the power consumption rate $E_i/E_T$ means the amount of power $E_i$ consumed in a corresponding section with respect to the total power consumption $E_T$, expressed in a numerical value, and the energy efficiency profit/loss value $M_i/E_i - M_S/E_T$ may mean the profit and loss of the current energy efficiency $M_i/E_i$ compared to the standard energy efficiency $M_S/E_T$ of the vehicle, which is calculated by the standard energy efficiency $M_S/E_T$ of the vehicle and the power consumed in the corresponding section $E_i$ compared to the driving distance $M_i$ in the corresponding section. Here, $M_S$ may mean the total drivable distance according to the standard energy efficiency. For example, the energy efficiency profit/loss value may be expressed as a positive value or a negative value. In addition, a section having a positive value means a section having a energy efficiency higher than the standard energy efficiency, and a section having a negative value means a section having a energy efficiency lower than the standard energy efficiency.

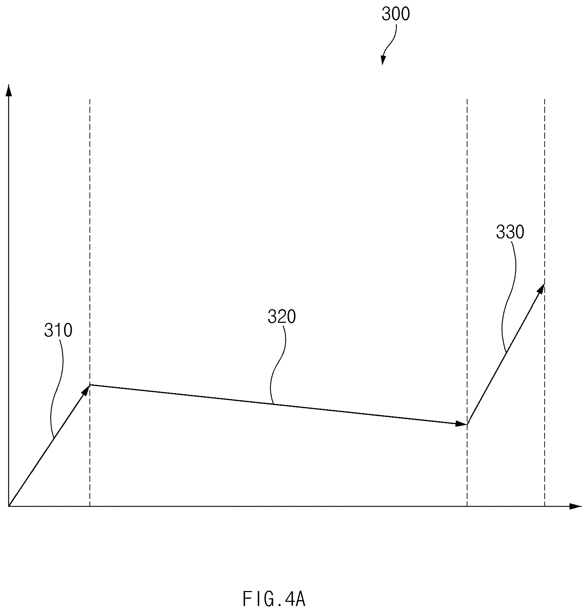

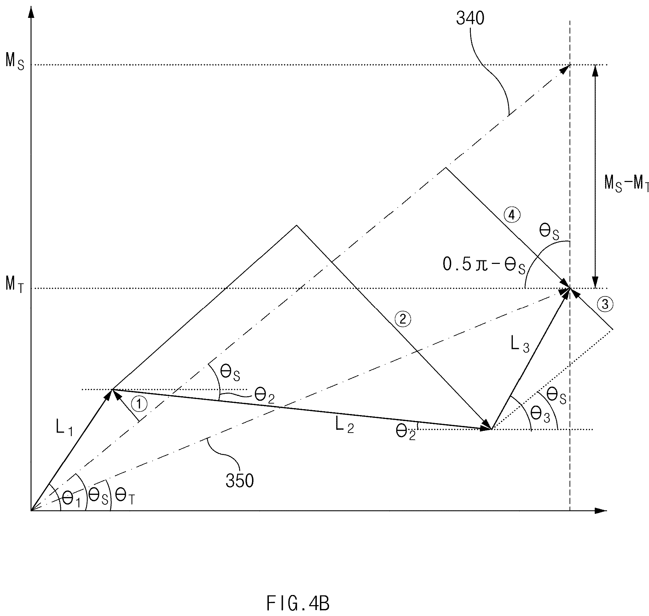

<Equation 1> may be explained through FIG. 4a, FIG. 4b, and <Equation 2> and <Equation 3> shown below.

FIG. 4a and FIG. 4b are views for explaining the operation of calculating a standard energy efficiency contribution according to an embodiment disclosed in this document.

Referring to FIGS. 4a and 4b, in the entire monitoring section 300 including a first section 310, a second section 320, and a third section 330, the difference ④ between the standard energy efficiency 340 of the vehicle and the current energy efficiency 350 of the vehicle may be expressed as a sum of the first standard energy efficiency contribution ① for the first section 310, the second standard energy efficiency contribution ② for the second section 320, and the third standard energy efficiency contribution ③ for the third section 330.

This difference in energy efficiency ④ may be derived through <Equation 2> shown below.

$(M_S - M_T)/E_T$ = ④$/(E_T * \cos(\theta_S))$ = (①+②+③)$/(E_T * \cos(\theta_S))$ = $1/(E_T * \cos(\theta_S)) * (L_1 * \sin(\theta_i - \theta_S) + L_2 * \sin(\theta_i - \theta_S) + L_3 * \sin(\theta_i - \theta_S))$     <Equation 2>

Based on <Equation 2>, the standard energy efficiency contribution may be derived through <Equation 3> shown below.

Standard energy efficiency contribution in section i (km/kwh) = $(L_i * \sin(\theta_i - \theta_S))/(E_T * \cos(\theta_S))$ = $(E_i * \sin(\theta_i - \theta_S))/(E_T * \cos(\theta_S) * \cos(\theta_i))$ = $(E_i * (\sin(\theta_i)\cos(\theta_S) - \cos(\theta_i)\sin(\theta_S)))/(E_T * \cos(\theta_S) * \cos(\theta_i))$ = $E_i/E_T * (M_i/E_i - M_S/E_T)$     <Equation 3>

According to an embodiment, an example of the standard energy efficiency contribution calculated based on <Equation 1> may be summarized in <Table 1> shown below.

[Table 1]

| <Table 1> | Section 1 | Section 2 | Section 3 |
|---|---|---|---|
| Driving distance | 6 km | 12 km | 8 km |
| Sectional energy consumption | 3 kwh | 3 kwh | 4 kwh |
| Standard energy efficiency | | | 3 km/kwh |
| Energy efficiency (Sectional energy efficiency) | 2 km/kwh | 4 km/kwh | 2 km/kwh |
| Entire section energy efficiency | | | 2.6 km/kwh |
| Power consumption rate | 0.3 | 0.3 | 0.4 |
| Energy efficiency profit/loss value | -1 | +1 | -1 |
| Standard energy efficiency contribution | -0.3 | 0.3 | -0.4 |

Referring to the <Table 1>, the sum of the standard energy efficiency and the standard energy efficiency contribution of each section (e.g., 3-(0.3)+(0.3)-(0.4)=2.6) is the same as the energy efficiency in the entire section (e.g., section 1 to section 3) (e.g., 26 km/10 kWh=2.6). In addition, it can be seen that although the energy efficiency of the first section (e.g., 2 km/kWh) and the energy efficiency of the third section (e.g., 2 km/kWh) are the same, the standard energy efficiency contribution of the first section (e.g., -0.3) and the standard energy efficiency contribution of the third section (e.g., -0.4) are different. This means that the standard energy efficiency contribution in the same energy efficiency section may vary according to the driving behavior of the driver. In this regard, the processor 140 may accurately analyze the factors that affect the energy efficiency through the standard energy efficiency contribution and provide the result to the driver.

As described above, the energy efficiency analysis device 30 may calculate the power consumption rate and the energy efficiency profit/loss value on the basis of driving information of the vehicle 10 acquired through the vehicle diagnosis device 20. However, this is only an example, and various embodiments are not limited thereto. For example, at least some of the power consumption rate and the energy efficiency profit/loss value may be calculated by the vehicle diagnosis device 20 or another external device and provided to the energy efficiency analysis device 30.

According to an embodiment, in calculating the standard energy efficiency contribution, the processor 140 may classify a monitoring section into a plurality of speed sections, and may further classify each speed section into a plurality of sections. According to an embodiment, the processor 140 may classify each speed section into a plurality of behavioral factors. Since the embodiments related to the behavioral factors have been described with reference to FIGS. 2a and 2b, they may not be described again here.

Explanation related to calculation of the standard energy efficiency contribution for a plurality of behavioral factors will be described with reference to FIG. 3b.

Referring to FIG. 3b, the processor 140 may classify the first section 210 of the monitoring section 200 into speed change sections such as a gear-shift acceleration 102 section 211 and a gear-shift deceleration 104 section 212. In addition, the processor 140 may classify the second section 220 of the monitoring section 200 into speed change sections such as a start acceleration 101 section 221, a stop deceleration 103 section 222, a gear-shift acceleration 102 section 223, and a gear-shift deceleration 104 section 224. In addition, the processor 140 may classify the third section 230 of the monitoring section 200 into speed change sections such as a start acceleration 101 section 231, a stop deceleration 103 section 232, a gear-shift deceleration 104 section 233, and a gear-shift acceleration 102 section 234.

According to an embodiment, the processor 140 may classify only some sections that satisfy specified conditions, among the start acceleration 101 section 221, the stop deceleration 103 section 222, the gear-shift acceleration 102 section 223, and the gear-shift deceleration 104 section 224 in the second section 220 of the monitoring section 200, as speed change sections. Of course, the processor 140 may also classify only some sections that satisfy specified conditions among the plurality of speed sections of the monitoring section 200 as speed change sections.

Thereafter, the processor 140 may calculate a standard energy efficiency contribution for each speed section.

As described above, the standard energy efficiency contribution may be calculated based on a section (e.g., a monitoring section), in which electric energy is consumed by driving of the vehicle 10. However, this is only an example, and various embodiments are not limited thereto. For example, the processor 140 may additionally calculate the standard energy efficiency contribution based on a section in which energy is consumed in a state where driving is not performed actually (e.g., a stopped state).

According to an embodiment, the processor 140 may calculate the power consumption rate on the basis of the power consumed in the stopped state. For example, the processor 140 may calculate a standard energy efficiency contribution for the stopped state on the basis of the power consumption rate calculated based on the power consumed by the air conditioning device (e.g., cooling device, heating device, etc.) and the energy efficiency profit/loss value calculated in the stopped state (e.g., driving distance 0 km).

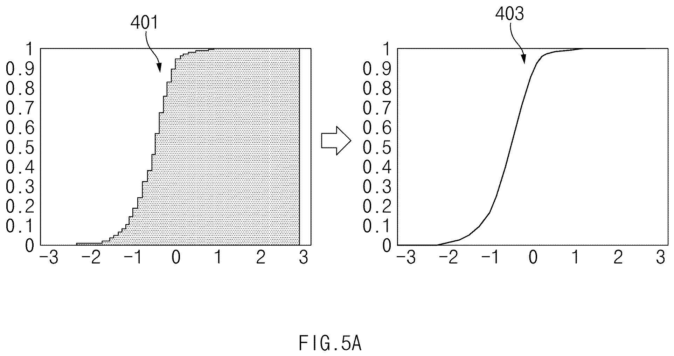

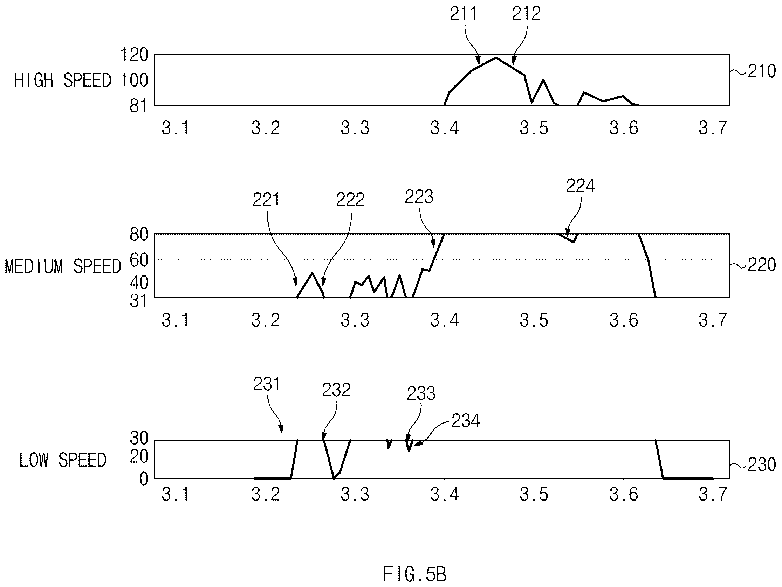

According to an embodiment, the processor 140 may calculate a score of the standard energy efficiency contribution for each of a plurality of behavioral factors on the basis of the calculated standard energy efficiency contribution. The operation of calculating a score by the processor 140 may be described with reference to FIGS. 5a and 5b.

FIG. 5a and FIG. 5b are views for explaining the operation of calculating scores for behavioral factors according to an embodiment disclosed in this document.

Referring to FIG. 5a, the processor 140 may calculate a score of a standard energy efficiency contribution for each of a plurality of behavioral factors on the basis of a probability distribution function related to the standard energy efficiency contribution for each of a plurality of behavioral factors. The probability distribution function (cumulative density function) may be a function indicating the probability of an arbitrary random variable to be lower than or equal to a specific value.

According to an embodiment, the processor 140 may estimate a probability distribution function on the basis of previously acquired data related to the standard energy efficiency contribution of each of the plurality of behavioral factors. The processor 140 may previously acquire data related to the standard energy efficiency contribution of each of a plurality of behavioral factors through the data acquisition unit 110. According to an embodiment, the processor 140 may acquire data related to past driving of the vehicle 10. In addition, according to an embodiment, the processor 140 may acquire data related to current or past driving of other vehicles (not shown), in addition to that of the vehicle 10. The previously acquired data may be big data stored in a server.

According to an embodiment, the processor 140 may calculate a probability distribution function on the basis of previously acquire data for each of a plurality of behavioral factors. As described above, the probability distribution function (cumulative density function) may be a function indicating a probability that an arbitrary random variable is smaller than or equal to a specific value. According to an embodiment, the probability distribution function (cumulative density function) may include a discrete probability mass function 401 and/or a continuous probability density function 403.

According to an embodiment, the processor 140 may calculate the probability of the standard energy efficiency contribution as a probability distribution function. For example, the processor 140 may calculate the standard energy efficiency contribution as a probability variable (i.e., x-axis or independent variable), and the probability of each standard energy efficiency contribution for being lower than or equal to a specific value as a function value (i.e., y-axis or dependent variable) of a probability variable function.

According to an embodiment, the processor 140 may calculate a discrete probability mass function 401 corresponding to the standard energy efficiency contribution, and estimate the discrete probability mass function 401 as a continuous probability density function 403. The discrete probability mass function 401 may be a probability distribution function having discrete values, and the continuous probability density function 403 may be a probability distribution function having continuous values. According to an embodiment, since the previously acquired data on the standard energy efficiency contribution of each of the plurality of behavioral factors are discrete values, the graph of the discrete probability mass function 401 may have discrete function values. In this case, there is a problem in that deviation of the probability increases at the boundary where the function values of the discrete probability mass function 401 increase. Therefore, the processor 140 may eliminate the deviation by estimating the discrete probability mass function 401 as the continuous probability density function 403. Through this, the processor 140 may calculate reliable probability values and scores.

Referring to FIG. 5b, the processor 140 may calculate a score of the standard energy efficiency contribution for each of the plurality of behavioral factors through a probability distribution function of each of the plurality of behavioral factors. According to an embodiment, the processor 140 may calculate a score based on a probability corresponding to the standard energy efficiency contribution for a specific behavioral factor of the vehicle 10 from a continuous probability density function 403 for the specific behavioral factor.

For example, FIG. 5b may be a continuous probability density function 403 of a standard energy efficiency contribution for a specific behavioral factor (e.g., start acceleration 101). When the standard energy efficiency contribution for the start acceleration 101 of the vehicle 10 is 0.2, the function value corresponding to the probability variable 0.2 in the continuous probability density function 403 may be 0.97. Accordingly, the processor 140 may calculate the score of the start acceleration 101 as 97 points.

In an embodiment, the higher the score of the standard energy efficiency contribution for a specific behavioral factor, the more likely the specific behavioral factor may positively affect the energy efficiency. On the other hand, the lower the score of the standard energy efficiency contribution for a specific behavioral factor, the more likely the specific behavioral factor may negatively affect the energy efficiency.

Therefore, the energy efficiency analysis device 30 may analyze the degree of each behavioral factor positively or negatively effecting the energy efficiency on the basis of the score of the standard energy efficiency contribution for each behavioral factor. In addition, the energy efficiency analysis device 30 may analyze the level of the current energy efficiency of the vehicle 10 compared to the energy efficiency of other vehicles. Therefore, users may objectively determine behavioral factors that positively or negatively affect the energy efficiency on the basis of the calculated score. Through this, users may improve their driving habits and improve the energy efficiency of the vehicle 10.

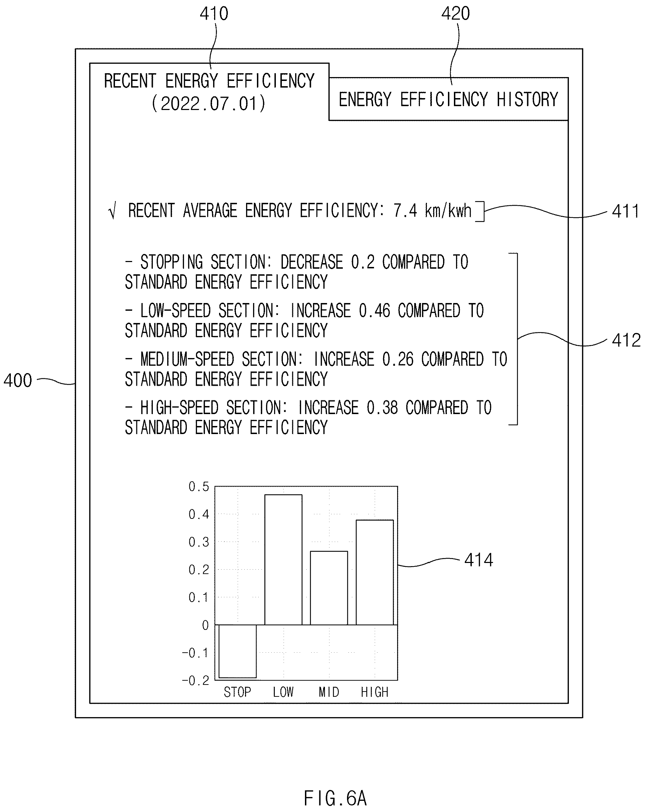

According to various embodiments, the processor 140 may output information related to the calculated standard energy efficiency contribution and score (i.e., energy efficiency contribution information). Details related to the energy efficiency contribution information will be described with reference to FIGS. 6a to 6e.

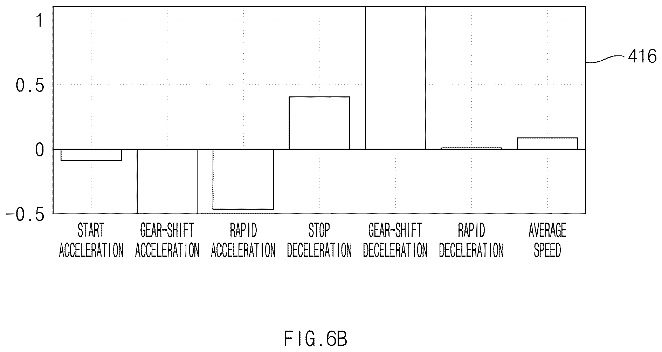

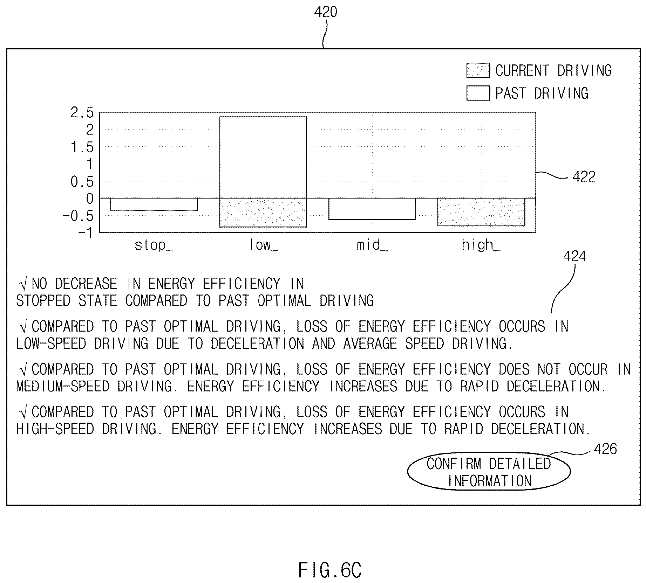

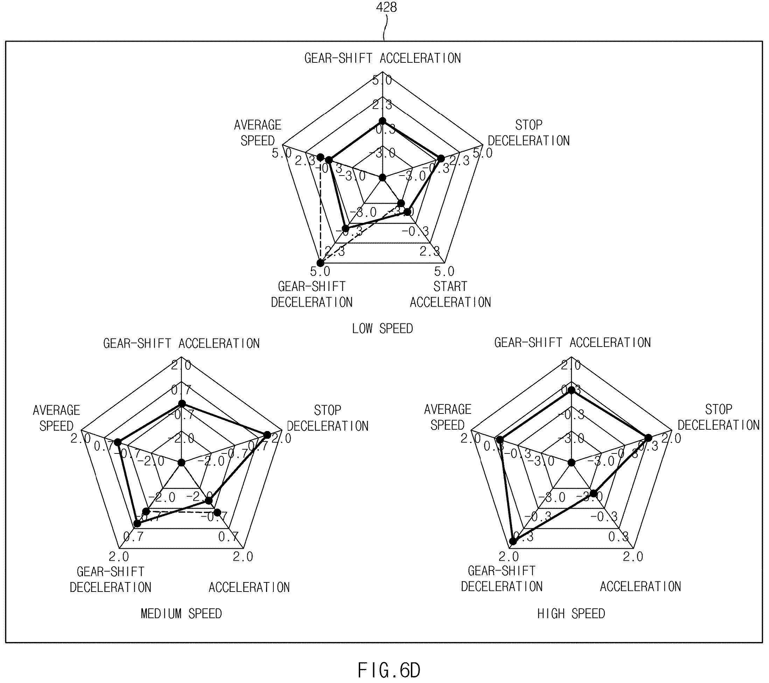

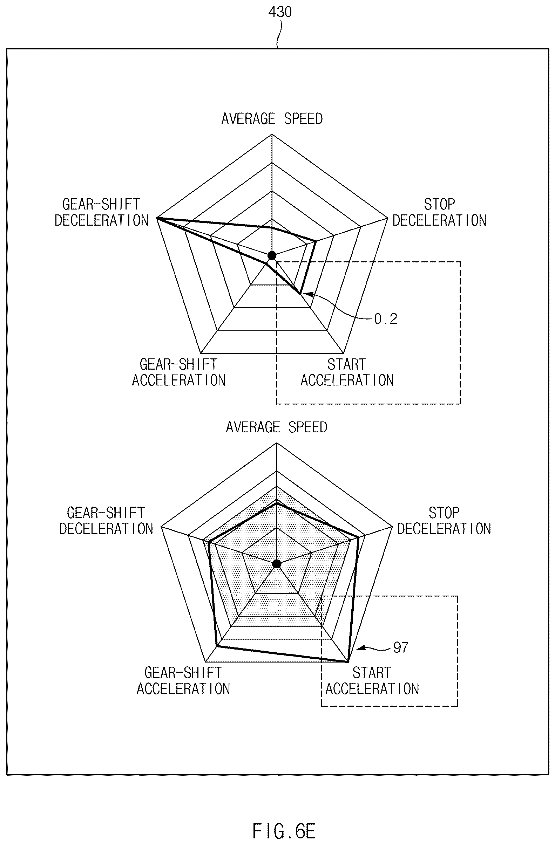

FIGS. 6a, 6b, 6c, 6d, and 6e are views for explaining the output operation of a energy efficiency analysis device according to an embodiment disclosed in this document.

Referring to FIG. 6a, the processor 140 may output energy efficiency contribution information 400 through the output device 130. According to an embodiment, the processor 140 may output energy efficiency contribution information 400 including first energy efficiency contribution information 410 related to recent energy efficiency (or recent driving) and second energy efficiency contribution information 420 related to energy efficiency history (or past driving history). According to an embodiment, the processor 140 may receive a user's input and selectively output the first energy efficiency contribution information 410 or the second energy efficiency contribution information 420. Alternatively, the processor 140 may output the first energy efficiency contribution information 410 and the second energy efficiency contribution information 420 together regardless of whether or not it receives a user's input.

According to an embodiment, the first energy efficiency contribution information 410 may include an average energy efficiency (e.g., recent average energy efficiency: 7.4 km/kWh) 411 according to recent driving and a standard energy efficiency contribution 412 for each speed section monitored in the recent driving. Additionally, the first energy efficiency contribution information 410 may include a graph 414 of the standard energy efficiency contribution for each monitored speed section. Through this, the driver may recognize a speed section that improves or reduces energy efficiency, and as a result, driving habits of the driver for improving energy efficiency may be induced.

Additionally or optionally, the processor 140 may provide a detailed standard energy efficiency contribution for at least any one speed section on the basis of a user's input while the first energy efficiency contribution information 410 is output.

Referring to FIG. 6b, the processor 140 may output a standard energy efficiency contribution 416 for each of a plurality of behavioral factors. For example, when any one speed section (e.g., a low-speed section) is selected through the standard energy efficiency contribution 412 of each speed section or the graph 414 of the standard energy efficiency contribution, the processor 140 may output a standard energy efficiency contribution 416 for each of the behavioral factors (e.g., start acceleration 101, gear-shift acceleration 102, stop deceleration 103, gear-shift deceleration 104, average speed 105, rapid acceleration, and rapid deceleration) for the selected speed section. Through this, the driver may recognize behaviors that relatively lower energy efficiency and behaviors that relatively improve energy efficiency in the selected speed section.

According to an embodiment, when the processor 140 outputs the fuel contribution information, it may also provide information related to a profit and loss cost generated according to the standard energy efficiency contribution. In this regard, the processor 140 may calculate the profit and loss cost by multiplying the standard energy efficiency contribution by a unit energy cost (e.g., cost per kWh). In addition, when the processor 140 outputs the fuel contribution information, it may also provide information on the ratio of at least a section with a high standard energy efficiency contribution or a section with a low standard energy efficiency contribution in the entire driving section.

According to an embodiment, the processor 140 may provide a result of comparing the standard energy efficiency contribution according to past driving and the standard energy efficiency contribution according to current driving through the second energy efficiency contribution information 420 related to the energy efficiency history. At this point, the processor 140 may select any one previously specified among the standard energy efficiency contributions according to a plurality of stored past driving, and compare it with the standard energy efficiency contribution according to the current driving. For example, at least one among past driving in which optimal energy efficiency driving is achieved, driving made immediately before the current driving, past driving performed on a route similar to that of the current driving, and a plurality of past driving performed over a predetermined period may be determined as a comparison target to be compared with the current driving.

Referring to FIG. 6c, the processor 140 may output second energy efficiency contribution information 420 including a graph 422 comparing the energy efficiency decreased or increased in the current driving with the energy efficiency of the past driving, and text information 424 about the comparison result.

Additionally or optionally, the second energy efficiency contribution information 420 may include an object (e.g., an icon for confirming detailed information) 426 that induces output of detailed information that has decreased or increased the energy efficiency in the current driving compared to the past driving. Accordingly, when a user's input on the object is detected, the processor 140 may output the detailed information.

Referring to FIG. 6d, the processor 140 may provide detailed information 428 on a section in which the energy efficiency is decreased or increased in the current driving compared to the past driving, or detailed information on behavioral factors that have decreased or increased the energy efficiency in that section. In FIG. 6d, the results of comparing the energy efficiency of the past driving and the energy efficiency of the current driving are provided as detailed information 428 through radial graphs, but various embodiments are not limited thereto.

Referring to FIG. 6e, the processor 140 may output detailed information 430 related to the score of a standard energy efficiency contribution. According to an embodiment, the processor 140 may output a standard energy efficiency contribution for each behavioral factor and/or a score of the standard energy efficiency contribution for each behavioral factor. It may be difficult for a user to grasp whether each behavioral factor has a positive or negative effect on the driving through the numerical value of the standard energy efficiency contribution for each behavioral factor. On the contrary, through the score of the standard energy efficiency contribution for each behavioral factor, the user may intuitively analyze whether each behavioral factor has a positive or negative effect on the energy efficiency. Therefore, the user may make an appropriate driving plan considering the energy efficiency and the behavioral factors.

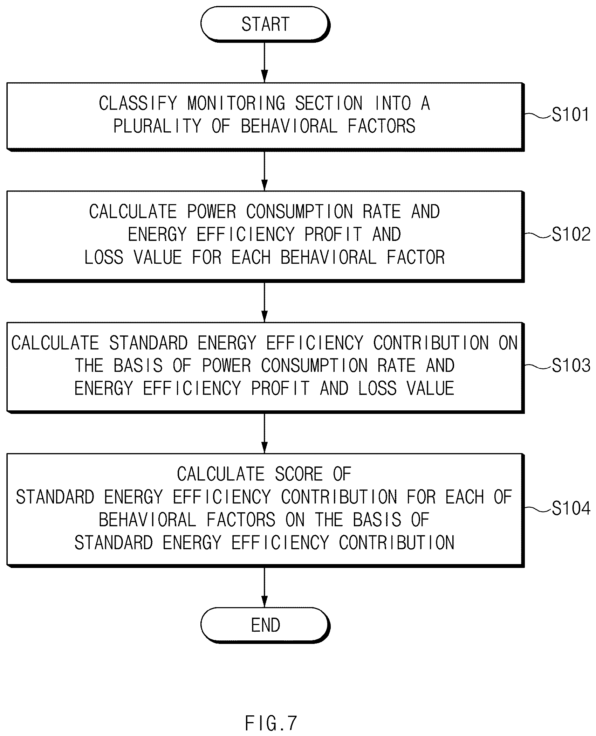

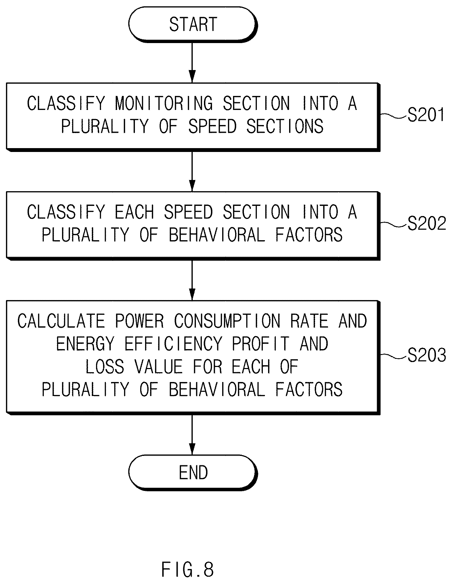

Hereinafter, the operation method of the energy efficiency analysis device 30 according to an embodiment will be described in detail with reference to FIGS. 7 and 8.

FIG. 7 is a flowchart for explaining the operation of a energy efficiency analysis device according to an embodiment disclosed in this document.

The operations shown in FIG. 7 may be performed through the energy efficiency analysis device 30 of FIG. 1b. Although the operations in the following embodiments may be performed sequentially, they are not necessarily performed sequentially. For example, the order of the operations may be changed, and at least two operations may be performed in parallel. In addition, at least one of the operations described below may be omitted according to embodiments.

Referring to FIG. 7, in operation S101, the processor 140 may classify (or segment) a monitoring section into a plurality of sections. According to an embodiment, the processor 140 may classify the monitoring section into a plurality of speed sections. According to an embodiment, the processor 140 may classify the monitoring section into a plurality of behavioral factors.

In operation S102, the processor 140 may calculate a power consumption rate and a energy efficiency profit/loss value for each behavioral factor. The power consumption rate means the amount of power consumed in each section with respect to the total power consumption in the monitoring section, expressed in a numerical value, and the energy efficiency profit/loss value may mean the profit or loss of the current energy efficiency compared to the standard energy efficiency of the vehicle (e.g., the official energy efficiency) expressed in a numerical value.

In operation S103, the processor 140 may calculate a standard energy efficiency contribution on the basis of the power consumption rate and the energy efficiency profit/loss value. The standard energy efficiency contribution may be information indicating the degree of influence on the profit or loss (e.g., increase or decrease) of the current energy efficiency of the vehicle 10 compared to the standard energy efficiency (e.g., official energy efficiency). According to an embodiment, the processor 140 may use <Equation 1> described above in calculating the standard energy efficiency contribution.

In operation S104, the processor 140 may calculate a score of the standard energy efficiency contribution for each of the behavioral factors on the basis of the calculated standard energy efficiency contribution. According to an embodiment, the processor 140 may calculate and/or estimate a probability distribution function related to the standard energy efficiency contribution for each of the plurality of behavioral factors. In addition, the processor 140 may calculate a score of the standard energy efficiency contribution for each of the plurality of behavioral factors on the basis of the probability distribution function.

FIG. 8 is a flowchart for explaining the operation of calculating a power consumption rate and a energy efficiency profit/loss value by a energy efficiency analysis device according to an embodiment disclosed in this document.

The operations shown in FIG. 8 may be performed through the energy efficiency analysis device 30 of FIG. 1b. Although the operations in the following embodiments may be performed sequentially, they are not necessarily performed sequentially. For example, the order of the operations may be changed, and at least two operations may be performed in parallel. In addition, at least one of the operations described below may be omitted according to embodiments.

Referring to FIG. 8, in operation S201, the processor 140 may classify a monitoring section into a plurality of speed sections. According to an embodiment, the processor 140 may classify the monitoring section into a low-speed section, a medium-speed section, and a high-speed section.

In operation S202, the processor 140 may classify each speed section into a plurality of behavioral factors. The plurality of behavioral factors may include at least one among a start acceleration 101, a gear-shift acceleration 102, a stop deceleration 103, a gear-shift deceleration 104 section, and an average speed 105. In addition, the energy efficiency analysis device 30 may also classify only some behavioral factors that satisfy a specified condition among a plurality of speed change sections included in each speed section.

In operation S203, the processor 140 may calculate a power consumption rate and a energy efficiency profit/loss value for each of the plurality of behavioral factors. Thereafter, the energy efficiency analysis device 30 may calculate a standard energy efficiency contribution for each of the plurality of behavioral factors.

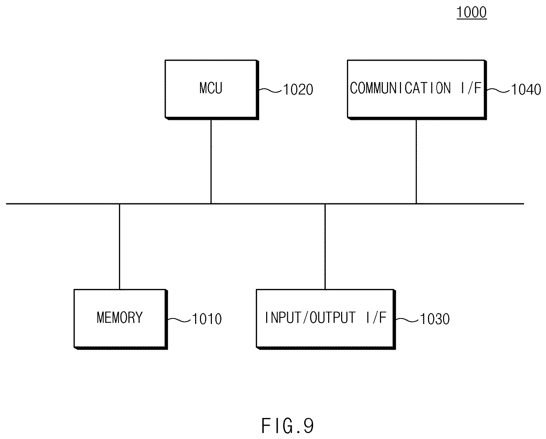

FIG. 9 is a block diagram showing the hardware configuration of a computing system configured to implement a energy efficiency analysis device according to an embodiment disclosed in this document.

Referring to FIG. 9, a computing system 1000 according to an embodiment disclosed in this document may include a memory 1010, an MCU 1020, an input/output I/F 1030, and a communication I/F 1040.

The memory 1010 may store various programs such as a driving characteristic data collection program, a latent variable extraction program, a driving speed profile generation program, a probability distribution analysis program, a energy efficiency analysis program, and the like of a vehicle 10. In addition, the memory 1010 may store various information including driving characteristic data, latent variables, and the like of vehicle 10.

The memory 1010 may be provided in plurality as needed. The memory 1010 may be a volatile memory or a non-volatile memory. As the volatile memory 1010, RAM, DRAM, SRAM, or the like may be used. As the non-volatile memory 1010, ROM, PROM, EAROM, EPROM, EEPROM, flash memories, or the like may be used. The examples of the memory 1010 listed above are only examples and are not limited to these examples.

The MCU 1020 may be a processor that executes various programs (e.g., a driving characteristic data collection program, a latent variable extraction program, a driving speed profile generation program, a probability distribution analysis program, a energy efficiency analysis program, etc.) stored in the memory 1010, processes various information including driving characteristic data, latent variables, and the like through these programs, and performs functions of the processor 140 included in the energy efficiency analysis device 30 shown in FIGS. 1a to 8 described above.

The input/output I/F 1030 may provide an interface configured to connect input devices (not shown) such as a keyboard, a mouse, a touch panel, and the like, output devices such as a display (not shown) and the like, and the MCU 1020, and transmit and receive data.

The communication I/F 1040 is a configuration that can transmit and receive various data with the server, and may be various devices that can support wired or wireless communication. For example, the energy efficiency analysis device 30 may transmit and receive various information, including the driving speed, energy efficiency, and the like of the vehicle 10, to and from separately provided external servers through the communication I/F 1040.

As described above, computer programs according to an embodiment disclosed in this document may be recorded in the memory 1010 and processed by the MCU 1020 to be implemented, for example, as a module that performs each of the functions shown in FIG. 1b.

As described above, although all the components constituting the embodiments disclosed in this document have been described as being combined as one piece or operating in combination, the embodiments disclosed in this document are not necessarily limited to such embodiments. That is, all the components may be selectively combined as one or more to operate within the scope of the objects of the embodiments disclosed in this document.

In addition, the terms "include," "comprise," or "have" described above mean that a corresponding component may be included unless otherwise specifically stated, and therefore should be interpreted as further including other components, rather than excluding other components. Unless defined otherwise, all terms including technical or scientific terms have the same meaning as commonly understood by those skilled in the art. Commonly used terms, such as terms defined in a dictionary, should be interpreted as being consistent with the contextual meaning of related techniques, and will not be interpreted in an ideally or excessively formal sense unless explicitly defined in this document.

Details of the disclosure described above schematically describe features of several embodiments so that those skilled in the art may better understand the aspects of the present disclosure. Those skilled in the art will easily understand that the present disclosure may be used as a basis for designing or modifying other structures to accomplish the same objects or achieve the same advantages of the embodiments introduced herein. Furthermore, those skilled in the art will recognize that such equivalent configurations do not depart from the scope of the present disclosure, and that various changes, substitutions, and modifications can be made herein without departing from the scope of the present disclosure.

**Claims**

1. An energy efficiency analysis device comprising:

   a data acquisition unit configured to acquire driving information of a vehicle in a specified monitoring section; and
   a processor configured to classify the specified monitoring section into a plurality of behavioral factors according to a driving state on the basis of the driving information, calculate a standard energy efficiency contribution, which is a degree of affecting a energy efficiency of the vehicle by each of the plurality of behavioral factors, and calculate a score for each of the plurality of behavioral factors on the basis of the standard energy efficiency contribution.

2. The energy efficiency analysis device according to claim 1, wherein the processor classifies the specified monitoring section into a plurality of speed sections that satisfy a specified speed condition on the basis of the driving information, classifies each of the plurality of speed sections into a plurality of behavioral factors that satisfy a specified speed change condition, and calculates a standard energy efficiency contribution for each of the plurality of behavioral factors.

3. The energy efficiency analysis device according to claim 2, wherein the processor classifies each of the plurality of speed sections into a plurality of behavioral factors on the basis of whether a starting speed or an ending speed is 0 in each of the plurality of speed sections.

4. The energy efficiency analysis device according to claim 1, wherein the processor calculates a energy efficiency profit/loss value indicating a profit or loss of a current energy efficiency of the vehicle compared to a standard energy efficiency of the vehicle on the basis of the driving information, and calculates the standard energy efficiency contribution on the basis of the energy efficiency profit/loss value.

5. The energy efficiency analysis device according to claim 4, wherein the processor calculates the standard energy efficiency contribution indicating a degree of affecting a profit or loss of the current energy efficiency by driving of the vehicle in the specified monitoring section compared to the standard energy efficiency, on the basis of the power consumption rate of the vehicle and the energy efficiency profit/loss value in the specified monitoring section.

6. The energy efficiency analysis device according to claim 1, wherein the processor calculates a score for each of the plurality of behavioral factors on the basis of a probability distribution function related to the standard energy efficiency contribution of each of the plurality of behavioral factors.

7. The energy efficiency analysis device according to claim 6, wherein the processor estimates the probability distribution function on the basis of previously acquired data related to the standard energy efficiency contribution of each of the plurality of behavioral factors, and calculates a score for each of the plurality of behavioral factors on the basis of a probability corresponding to the standard energy efficiency contribution of the vehicle from the probability distribution function.

8. An energy efficiency analysis method comprising the steps of:

classifying, on the basis of driving information of a vehicle acquired in a specified monitoring section, the specified monitoring section into a plurality of behavioral factors according to a driving state;
calculating a standard energy efficiency contribution, which is a degree of affecting a energy efficiency of the vehicle by each of the plurality of behavioral factors; and
calculating a score for each of the plurality of behavioral factors on the basis of the standard energy efficiency contribution.

9. The energy efficiency analysis method according to claim 8, wherein the step of classifying the specified monitoring section into a plurality of behavioral factors includes the steps of:

classifying the specified monitoring section into a plurality of speed sections that satisfy a specified speed condition on the basis of the driving information;
classifying each of the plurality of speed sections into a plurality of behavioral factors that satisfy a specified speed change condition; and
calculating a standard energy efficiency contribution for each of the plurality of behavioral factors.

10. The energy efficiency analysis method according to claim 9, wherein the step of classifying the specified monitoring section into a plurality of behavioral factors includes the step of classifying each of the plurality of speed sections into a plurality of behavioral factors on the basis of whether a starting speed or an ending speed is 0 in each of the plurality of speed sections.

11. The energy efficiency analysis method according to claim 8, wherein the step of calculating a standard energy efficiency contribution includes the steps of:

calculating a energy efficiency profit/loss value indicating a profit or loss of a current energy efficiency of the vehicle compared to a standard energy efficiency of the vehicle on the basis of the driving information; and
calculating the standard energy efficiency contribution on the basis of the energy efficiency profit/loss value.

12. The energy efficiency analysis method according to claim 11, further comprising, after the step of calculating a energy efficiency profit/loss value, the step of calculating the standard energy efficiency contribution indicating a degree of affecting a profit or loss of the current energy efficiency by driving of the vehicle in the specified monitoring section compared to the standard energy efficiency, on the basis of the power consumption rate of the vehicle and the energy efficiency profit/loss value in the specified monitoring section.

13. The energy efficiency analysis method according to claim 8, wherein the step of calculating a score for each of the plurality of behavioral factors includes the step of calculating a score for each of the plurality of behavioral factors on the basis of a probability distribution function related to the standard energy efficiency contribution of each of the plurality of behavioral factors.

14. The energy efficiency analysis method according to claim 13, wherein the step of calculating a score for each of the plurality of behavioral factors includes the steps of:

estimating the probability distribution function on the basis of previously acquired data related to the standard energy efficiency contribution of each of the plurality of behavioral factors; and
calculating a score for each of the plurality of behavioral factors on the basis of a probability corresponding to the standard energy efficiency contribution of the vehicle from the probability distribution function.

100

10

VEHICLE
DIAGNOSIS
DEVICE
20

ENERGY
EFFICIENCY
ANALYSIS DEVICE
30

FIG.1A

ENERGY EFFICIENCY ANALYSIS DEVICE
30

DATA ACQUISITION UNIT
110

MEMORY
120

OUTPUT DEVICE
130

PROCESSOR
140

FIG.1B

INCLUDE POINTS
WHERE SPEED IS ZERO

DO NOT INCLUDE POINTS
WHERE SPEED IS ZERO

ACCELERATION

START
ACCELERATION
101

GEAR-SHIFT
ACCELERATION
102

OTHERS

AVERAGE SPEED
105

DECELERATION

STOP
DECELERATION
103

GEAR-SHIFT
DECELERATION
104

FIG.2A

FIG.2B

FIG.3A

FIG.3B

300

330

320

310

FIG.4A

FIG.4B

FIG.5A

EP 4 734 080 A1

FIG.5B

410 420

RECENT ENERGY EFFICIENCY
(2022.07.01)

ENERGY EFFICIENCY HISTORY

√ RECENT AVERAGE ENERGY EFFICIENCY: 7.4 km/kwh ⟩ ~ 411

- STOPPING SECTION: DECREASE 0.2 COMPARED TO
STANDARD ENERGY EFFICIENCY

- LOW-SPEED SECTION: INCREASE 0.46 COMPARED TO
STANDARD ENERGY EFFICIENCY

- MEDIUM-SPEED SECTION: INCREASE 0.26 COMPARED TO
STANDARD ENERGY EFFICIENCY

- HIGH-SPEED SECTION: INCREASE 0.38 COMPARED TO
STANDARD ENERGY EFFICIENCY

~ 412

400 ~

~ 414

| | STOP | LOW | MID | HIGH |

400

FIG.6A

FIG.6B

420

√ NO DECREASE IN ENERGY EFFICIENCY IN
STOPPED STATE COMPARED TO PAST OPTIMAL DRIVING

√ COMPARED TO PAST OPTIMAL DRIVING, LOSS OF ENERGY EFFICIENCY OCCURS IN
LOW-SPEED DRIVING DUE TO DECELERATION AND AVERAGE SPEED DRIVING.

√ COMPARED TO PAST OPTIMAL DRIVING, LOSS OF ENERGY EFFICIENCY DOES NOT OCCUR IN
MEDIUM-SPEED DRIVING. ENERGY EFFICIENCY INCREASES DUE TO RAPID DECELERATION.

√ COMPARED TO PAST OPTIMAL DRIVING, LOSS OF ENERGY EFFICIENCY OCCURS IN
HIGH-SPEED DRIVING. ENERGY EFFICIENCY INCREASES DUE TO RAPID DECELERATION.

FIG.6C

FIG.6D

FIG.6E

START

CLASSIFY MONITORING SECTION INTO A
PLURALITY OF BEHAVIORAL FACTORS — S101

CALCULATE POWER CONSUMPTION RATE AND
ENERGY EFFICIENCY PROFIT AND
LOSS VALUE FOR EACH BEHAVIORAL FACTOR — S102

CALCULATE STANDARD ENERGY EFFICIENCY CONTRIBUTION ON
THE BASIS OF POWER CONSUMPTION RATE AND
ENERGY EFFICIENCY PROFIT AND LOSS VALUE — S103

CALCULATE SCORE OF
STANDARD ENERGY EFFICIENCY CONTRIBUTION FOR EACH OF
BEHAVIORAL FACTORS ON THE BASIS OF
STANDARD ENERGY EFFICIENCY CONTRIBUTION — S104

END

FIG.7

START

CLASSIFY MONITORING SECTION INTO A PLURALITY OF SPEED SECTIONS — S201

CLASSIFY EACH SPEED SECTION INTO A PLURALITY OF BEHAVIORAL FACTORS — S202

CALCULATE POWER CONSUMPTION RATE AND ENERGY EFFICIENCY PROFIT AND LOSS VALUE FOR EACH OF PLURALITY OF BEHAVIORAL FACTORS — S203

END

FIG.8

1000

```
┌──────────────┐                    ┌──────────────────────┐
│     MCU      │~1020               │  COMMUNICATION I/F   │~1040
└──────┬───────┘                    └───────────┬──────────┘
       │                                        │
───────┴────────────────┬───────────────────────┴──────────
                         │
       ┌──────────────┐  │         ┌──────────────────────┐
       │   MEMORY     │~1010       │   INPUT/OUTPUT I/F    │~1030
       └──────────────┘            └──────────────────────┘
```

FIG.9

## INTERNATIONAL SEARCH REPORT

| International application No. |
| --- |
| **PCT/KR2024/012332** |

| A. | CLASSIFICATION OF SUBJECT MATTER |
| --- | --- |

**G07C 5/02**(2006.01)i; **G01R 31/00**(2006.01)i; **G01R 22/06**(2006.01)i; **G07C 5/00**(2006.01)i; **B60L 3/12**(2006.01)i

According to International Patent Classification (IPC) or to both national classification and IPC

| B. | FIELDS SEARCHED |
| --- | --- |

Minimum documentation searched (classification system followed by classification symbols)

G07C 5/02(2006.01); B60L 11/18(2006.01); B60L 3/00(2006.01); B60R 16/02(2006.01); B60T 1/06(2006.01); F02D 45/00(2006.01); G01C 21/00(2006.01); G01F 9/00(2006.01); G06Q 50/26(2012.01); G06Q 50/30(2012.01); G08G 1/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 모니터링(monitoring), 구간(section), 데이터(data), 구분(segmentation), 프로세서(processor), 속도(speed), 함수(function)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2016-018306 A (FUJI HEAVY IND., LTD.) 01 February 2016 (2016-02-01)<br>See paragraphs [0019]-[0021], [0030]-[0041], [0056]-[0082] and [0098]-[0107] and figures 1-2 and 8-11. | 1-14 |
| A | JP 2001-082243 A (NISSAN MOTOR CO., LTD.) 27 March 2001 (2001-03-27)<br>See paragraphs [0029]-[0039] and figures 1-2. | 1-14 |
| A | JP 2009-250930 A (NISSAN MOTOR CO., LTD.) 29 October 2009 (2009-10-29)<br>See paragraphs [0028]-[0040] and figure 2. | 1-14 |
| A | JP 2018-061364 A (MITSUBISHI MOTORS CORP.) 12 April 2018 (2018-04-12)<br>See claim 1 and figures 1-2. | 1-14 |
| A | KR 10-2015-0055130 A (KIM, Jong Sig) 21 May 2015 (2015-05-21)<br>See claim 1 and figure 1. | 1-14 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **25 November 2024** | **26 November 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/012332**

| Patent document cited in search report | | | Publication date (day/month/year) | Patent family member(s) | | | Publication date (day/month/year) |
|---|---|---|---|---|---|---|---|
| JP | 2016-018306 | A | 01 February 2016 | JP | 6457752 | B2 | 23 January 2019 |
| JP | 2001-082243 | A | 27 March 2001 | | None | | |
| JP | 2009-250930 | A | 29 October 2009 | JP | 5050973 | B2 | 17 October 2012 |
| JP | 2018-061364 | A | 12 April 2018 | CN | 107918309 | A | 17 April 2018 |
| | | | | EP | 3305583 | A1 | 11 April 2018 |
| | | | | JP | 6738045 | B2 | 12 August 2020 |
| | | | | US | 10600262 | B2 | 24 March 2020 |
| | | | | US | 2018-0102002 | A1 | 12 April 2018 |
| KR | 10-2015-0055130 | A | 21 May 2015 | | None | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230110809